# FASCICULE DE BREVET EUROPEEN

(11) **EP 2 783 423 B1**
(45) Date de publication et mention de la délivrance du brevet: **05.12.2018**
(21) Numéro de dépôt: 12783575.9
(22) Date de dépôt: 31.10.2012
(51) Int. Cl.: H01R 12/72

(54) **PROCÉDÉ POUR LA MISE EN CONTACT D'UNE CARTE IMPRIMÉE ÉLECTRONIQUE AVEC UNE PLURALITÉ D'ÉLÉMENTS DE CONTACTS DANS UN BOITIER RECEVANT OU ENTOURANT LA CARTE IMPRIMÉE ÉLECTRONIQUE ET BOITIER**
VERFAHREN ZUR PLAZIERUNG EINER ELEKTONISCHEN LEITERPLATTE IN KONTAKT MIT MEHREREN KONTAKTELEMENTEN IN EINEM GEHÄUSE ZUR AUFNAME ODER UMSCHLIESSUNG DER ELEKTRONISCHEN LEITERPLATTE UND GEHÄUSE
METHOD FOR PLACING AN ELECTRONIC PRINTED CARD IN CONTACT WITH A PLURALITY OF CONTACT ELEMENTS IN A HOUSING RECEIVING OR SURROUNDING THE ELECTRONIC PRINTED CARD AND HOUSING

(30) Priorité: 26.11.2011 DE 102011119576; 26.04.2012 FR 1201226
(43) Date de publication de la demande: 01.10.2014
(73) Titulaire: Johnson Controls Automotive Electronics SAS, 95892 Cergy-Pontoise Cedex (FR)
(72) Inventeur: BOX, Benoit, 95290 L'Isle Adam (FR)
(74) Mandataire: Schwöbel, Thilo K.
(86) Numéro de dépôt international: PCT/EP2012/071635
(87) Numéro de publication internationale: WO 2013/075919

(56) Documents cités:
- DE-A1- 4 324 917
- DE-A1-102006 025 977
- JP-A- 4 277 474
- JP-A- 2000 294 323
- US-A- 5 904 581
- US-A- 5 910 025

## Description

L'invention concerne un procédé pour la mise en contact d'une carte imprimée électronique avec une pluralité d'éléments de contact dans un boîtier recevant ou entourant la carte imprimée électronique, ainsi qu'un boîtier et des contacts formés en conséquence.

Dans l'état de la technique, les contacts sont disposés dans le boîtier respectif, de préférence dans la zone d'une liaison par enfichage, de telle sorte qu'une première extrémité des contacts dépasse vers l'extérieur, alors qu'une deuxième extrémité dépasse dans un espace intérieur du boîtier. Dans ce cas, les contacts sont surmoulés dans leur zone centrale de préférence avec le matériau du boîtier. L'extrémité côté intérieur des contacts est en outre formée à chaque fois de telle sorte qu'elle est formée de façon correspondante à des parties de logement dans une carte imprimée électronique, la carte imprimée électronique étant emboîtée sur les contacts et étant reliée, par exemple soudée, de préférence par adhésion de matière. D'autres divulgations concernent les documents DE 10 2006 025 977 A1 et JP 4 277 474 A.

L'objectif de la présente invention est de proposer un procédé amélioré par rapport à l'état de la technique pour la mise en contact d'une carte imprimée électronique avec des contacts dans un boîtier recevant ou entourant la carte imprimée électronique et des contacts formés en conséquence.

L'objectif est atteint selon l'invention avec un procédé pour la mise en contact d'une carte imprimée électronique selon la revendication 1.

L'objectif est atteint selon l'invention également avec un boitier selon la revendication 3. Sur la carte imprimée électronique sont disposés, du côté avant, des évidements (de contact), qui sont formés de façon correspondante aux extrémités côté intérieur des éléments de contact respectifs, en particulier aux extensions en forme d'ailes. Dans ce cas, les évidements présentent une surface électroconductrice, de préférence métallique, qui permet une mise en contact entre la carte imprimée et les extensions en forme d'ailes des contacts.

Dans le procédé pour la mise en contact d'une carte imprimée électronique avec des contacts dans un boîtier recevant ou entourant la carte imprimée électronique, la carte imprimée électronique est insérée ou poussée dans le boîtier de telle sorte que l'extrémité côté intérieur des contacts est disposée avec les extensions en forme d'ailes dans l'évidement respectif de la carte imprimée. Dans ce cas, les extensions flexibles et en forme d'ailes sont déformées, génèrent une résistance contre cette déformation et appliquent de ce fait une force d'appui sur les évidements de la carte imprimée.

De cette façon, on permet une mise en contact électrique sûre entre le contact et l'évidement sur la carte imprimée électronique, une telle mise en contact électrique étant particulièrement résistante aux vibrations, par exemple contrairement à un assemblage soudé classique.

Ainsi, on peut avoir un agencement simple de la carte imprimée électronique dans le boîtier, dans lequel en particulier une sollicitation mécanique de la carte imprimée pendant le montage dans le boîtier est réduite de façon significative.

Ainsi, on évite en particulier un endommagement du contact et/ou de la carte imprimée pendant le montage. Un risque d'interruption de la mise en contact électrique entre le contact et la carte imprimée est également réduit par la sollicitation mécanique réduite.

Selon l'invention, les extensions flexibles sont au moins partiellement fléchies dans leur deuxième position.

De par une telle réalisation d'un dispositif d'affichage, il est avantageusement possible qu'une force de rappel - dû à la flexion des extensions flexibles - est réalisé qui assure le contact entre la carte imprimée électronique et les éléments de contact.

Un perfectionnement particulièrement préféré de l'invention réside dans le fait que les extensions flexibles sont, dans leur deuxième position,
-- fléchies de manière élastique ou
-- fléchies de manière en partie élastique et en partie plastique.

De par une telle réalisation d'un dispositif d'affichage, il est avantageusement possible que, lorsque les extension flexibles sont fléchies de manière élastique, le contact électriquement contucteur peut être interrompu (c'est à dire la carte imprimée électronique peut être sortie du boîtier) ou lorsque les extension flexibles sont fléchies de manière en partie élastique et en partie plastique, le contact électriquement contucteur peut être réalisé avec une force maximale de rappel des extensions flexibles.

Selon l'invention, les extensions flexibles sont au moins partiellement fléchies dans leur deuxième position.

Encore un autre perfectionnement particulièrement préféré du boîtier selon la présente invention réside dans le fait que les extensions flexibles sont, dans leur deuxième position,
-- fléchies de manière élastique, ou
-- fléchies de manière en partie élastique et en partie plastique.

Un perfectionnement particulièrement préféré de l'invention réside dans le fait que le boîtier comprend un élément de fiche disposé du côté extérieur du le boîtier.

Selon l'invention, chaque élément de contact comprend, à l'endroit de sa deuxième extrémité, deux extensions flexibles en forme d'ailes.

D'autres caractéristiques et avantages de l'invention ressortiront de la lecture de la description qui suit d'un mode de réalisation particulier non limitatif de la présente invention.

### BREVE DESCRIPTION DES DESSINS

L'invention sera mieux comprise grâce à la description ci-après, qui se rapporte à des modes de réalisation préférés, donnés à titre d'exemple non limitatifs et expliqués avec références au dessin schématique annexé, dans lequel :
la figure 1 montre schématiquement une représentation éclatée d'une unité de commande électronique selon l'état de la technique,
la figure 2 montre schématiquement une représentation en perspective d'un contact selon l'état de la technique,
la figure 3 montre schématiquement une représentation en perspective d'un contact selon l'invention avec des extensions en forme d'ailes,
la figure 4 montre schématiquement une représentation en perspective d'une moitié de boîtier inférieure avec des contacts selon l'invention,
la figure 5 montre schématiquement une vue de dessus d'un processus de mise en contact entre une pluralité de contacts et une carte imprimée,
la figure 6 montre schématiquement une vue de dessus d'un processus de mise en contact achevé entre une pluralité de contacts et une carte imprimée,
la figure 7 montre schématiquement une représentation en perspective d'un boîtier avec une ouverture de logement côté avant pour la carte imprimée et
la figure 8 montre schématiquement une représentation en perspective d'un boîtier avec une ouverture de logement côté avant pour la carte imprimée et une carte imprimée disposée dans le boîtier.

### DESCRIPTION DES DESSINS

Des exemples de réalisation de l'invention sont expliqués de façon plus détaillée ci-dessous à l'aide de dessins.

Sur tous les dessins, des parties qui se correspondent sont repérées avec les mêmes références.

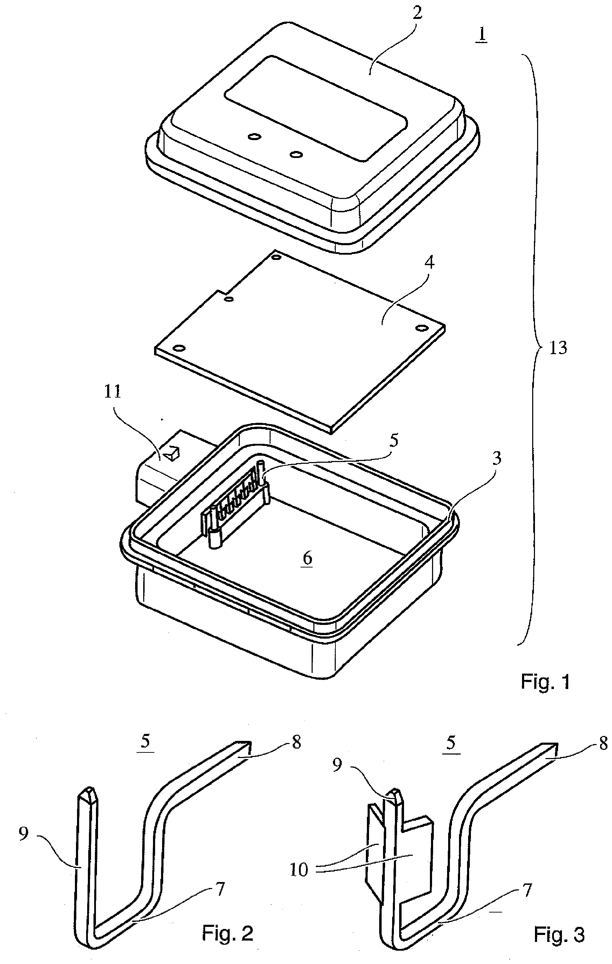

La figure 1 montre schématiquement une représentation éclatée d'une unité de commande 1 électronique selon l'état de la technique. Une telle unité de commande 1 électronique est conçue par exemple sous forme d'appareil de commande de moteur et/ou d'appareil de commande de boîte de vitesses et comprend un boîtier 13, qui est constitué d'une moitié de boîtier supérieure 2 et d'une moitié de boîtier inférieure 3, et une carte imprimée 4 électronique. Le boîtier 13 est divisé ici dans le sens horizontal en les moitiés de boîtier 2, 3.

Sur et/ou dans l'une des moitiés de boîtier 2, 3 est conçue au moins une liaison par enfichage 11 classique, qui comprend une pluralité de contacts 5 (aussi appelés éléments de contact 5), lesquels sont disposés les uns à côté des autres de préférence dans au moins une rangée. Dans ce cas, les contacts 5 sont disposés dans l'une des moitiés de boîtier 2, 3 de telle sorte qu'une première extrémité 8 des contacts 5 dépasse vers l'extérieur, alors qu'une deuxième extrémité 9 dépasse dans un espace intérieur 6 du boîtier 13.

La figure 2 montre schématiquement une représentation en perspective d'un tel contact 5 selon l'état de la technique.

Afin de permettre un agencement mécanique et étanche aux fluides sûr des contacts 5 dans au moins l'une des moitiés de boîtier 2, 3, les contacts 5 sont surmoulés dans leur zone centrale 7 de préférence avec le matériau du boîtier. L'extrémité 9 côté intérieur des contacts 5 est formée en outre à chaque fois de telle sorte qu'elle est formée de façon correspondante à des parties de logement dans la carte imprimée 4 électronique, la carte imprimée 4 électronique étant emboîtée sur les contacts 5 et étant reliée, par exemple soudée, de préférence par adhésion de matière.

Les moitiés de boîtier 2, 3 sont formées de préférence à base d'un matériau polymère thermoplastique et sont reliées l'une à l'autre par adhésion de matière après la mise en place de la carte imprimée 4 sur les contacts 5 au moyen d'un procédé classique, en particulier un procédé de soudage. Un tel soudage s'effectue de façon particulièrement préférée avec un procédé de soudage par vibration.

La figure 3 montre schématiquement une représentation en perspective d'un contact 5 selon l'invention avec des extensions 10 en forme d'ailes. Selon l'invention, l'extrémité 9 côté intérieur des contacts 5 présente au moins une, de préférence deux extensions 10 en forme d'ailes, qui sont conçues flexibles au moins par endroits. Dans ce cas, les extensions 10 en forme d'ailes sont disposées de préférence sur des côtés opposés du contact 5.

Le contact 5 est formé à base d'un matériau électroconducteur, de préférence métallique, les extensions 10 en forme d'ailes étant formées ou moulées d'un seul tenant sur celui-ci.

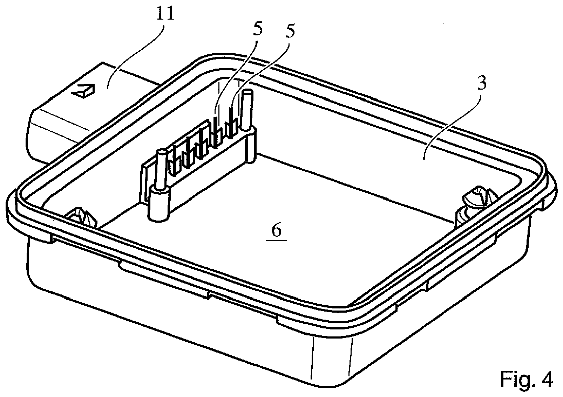

La figure 4 montre schématiquement une représentation en perspective d'une moitié de boîtier 3 inférieure avec des contacts 5 selon l'invention.

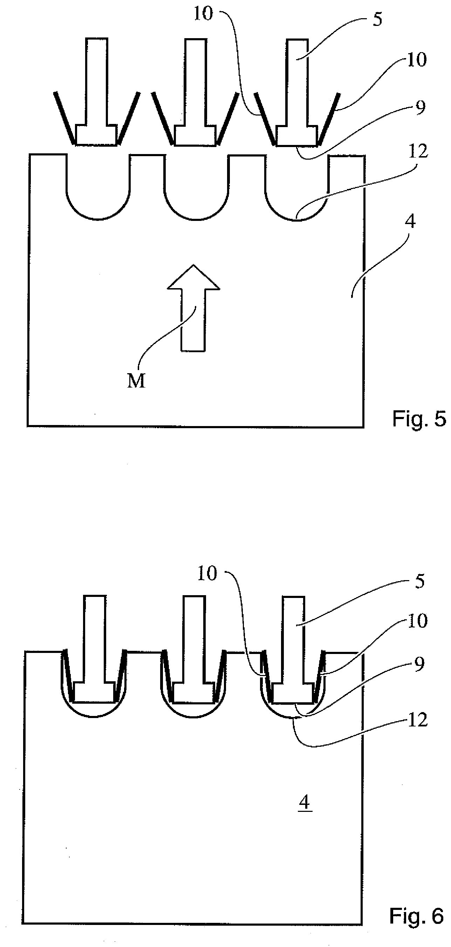

La figure 5 montre schématiquement une vue de dessus d'une opération de mise en contact entre une pluralité de contacts 5 avec des extensions 10 en forme d'ailes et une carte imprimée 4.

Sur la carte imprimée 4 électronique sont disposés côté avant des évidements 12 (aussi appelés évidements de contact 12), qui sont formés de façon correspondant aux extrémités 9 côté intérieur des contacts 5 respectifs, en particulier à leurs extensions 10 en forme d'ailes. Dans ce cas, les évidements 12 sont conçus par exemple en forme de fente avec une extrémité arrondie. Les évidements 12 présentent une surface électroconductrice, de préférence métallique, qui permet une mise en contact électrique entre la carte imprimée 4 et les extensions 10 en forme d'ailes des contacts 5.

La figure 6 montre schématiquement une vue de dessus d'une opération de mise en contact achevée entre une pluralité de contacts 5 et une carte imprimée 4.

Dans le procédé de mise en contact d'une carte imprimée 4 électronique avec des contacts 5 dans un boîtier 13 recevant ou entourant la carte imprimée 4 électronique, la carte imprimée 4 électronique est insérée ou poussée dans le sens du montage M dans le boîtier 13 de telle sorte que l'extrémité 9 côté intérieur des contacts 5 est disposée avec les extensions 10 en forme d'ailes dans l'évidement 12 respectif de la carte imprimée 4. Dans ce cas, les extensions 10 en forme d'ailes et flexibles sont déformées, génèrent une résistance contre cette déformation et appliquent de ce fait une force d'appui sur les évidements 12 de la carte imprimée 4.

De cette façon, en particulier par l'effet de la force d'appui, on permet une mise en contact électrique sûre entre le contact 5 et l'évidement 12 respectif sur la carte imprimée 4 électronique, une telle mise en contact électrique étant particulièrement résistante aux vibrations, par exemple contrairement à un assemblage soudé classique.

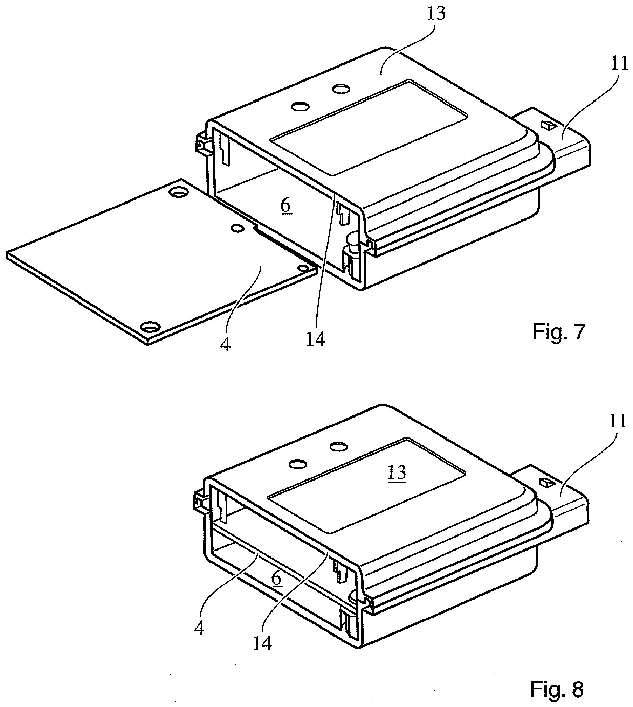

La figure 7 montre schématiquement une représentation en perspective d'un boîtier 13 avec une ouverture de logement 14 côté avant pour la carte imprimée 4. Contrairement à l'état de la technique, la carte imprimée 4 est poussée côté avant sur les contacts 5 et sur leurs extensions 10 en forme d'ailes, de sorte que cette opération peut s'effectuer de préférence par l'ouverture de logement 14 côté avant du boîtier 13. Ainsi, le boîtier est divisé verticalement, des rails de guidage latéraux pouvant être conçus dans le boîtier pour la carte imprimée 4, lesquels rails simplifient le montage.

Dans une variante de réalisation non représentée, les contacts 5 selon l'invention peuvent être utilisés avec les extensions 10 en forme d'ailes dans un boîtier divisé horizontalement selon l'état de la technique.

La figure 8 montre schématiquement une représentation en perspective d'un boîtier avec une ouverture de logement côté avant pour la carte imprimée 4 et une carte imprimée 4 disposée dans le boîtier.

### Liste des signes de référence :

- 1: unité de commande
- 2: moitié de boîtier supérieure
- 3: moitié de boîtier inférieure
- 4: carte imprimée électronique
- 5: élément de contact
- 6: espace intérieur
- 7: zone centrale
- 8: première extrémité
- 9: deuxième extrémité
- 10: extension en forme d'aile
- 11: liaison par enfichage
- 12: évidement de contact
- 13: boîtier
- 14: ouverture de logement
- M: sens de montage

## Revendications

1. Procédé pour la mise en contact d'une carte imprimée (4) électronique avec une pluralité d'éléments de contact (5) dans un boîtier (13) recevant ou entourant la carte imprimée (4) électronique,
la carte imprimée (4) électronique étant réceptionnée dans le boîtier (13),
la carte imprimée (4) électronique comprenant une pluralité d'évidements de contact (12),
les éléments de contact (5) comprenant une première extrémité (8) du côté extérieur du boîtier (13) et une deuxième extrémité (9) du côté intérieur du boîtier (13), chacun des éléments de contact (5) comprenant, à l'endroit de sa deuxième extrémité (9), deux extensions fléxibles (10) en forme d'ailes capables d'être positionnées dans une première position de repos et une deuxième position de contact,
le procédé comprenant :
-- une première étape pendant laquelle la carte imprimée (4) électronique est positionnée relative au boîtier (13) de telle manière que les deuxièmes extrémités (9) des l'éléments de contact (5) sont localisées en face des évidements de contact (12), les extensions flexibles (10) étant positionnés dans leur première position, et
-- une deuxième étape pendant laquelle la carte imprimée (4) électronique est électriquement contactée par l'intermédiaire de, d'une part, la pluralité d'évidements de contact (12) et, d'autre part, les extensions flexibles (10) de la deuxième extrémité (9) des éléments de contact (5), les extensions flexibles (10) étant positionnés dans leur deuxième position et au moins partiellement fléchies dans leur deuxième position.

2. Procédé selon la la revendication 1, **caractérisé en ce que** les extensions flexibles (10) sont, dans leur deuxième position, fléchies de manière élastique.

3. Boîtier (13) avec des éléments de contact (5) pour la mise en contact d'une carte imprimée (4) électronique, le boîtier (13) pouvant recevoir ou entourer une carte imprimée (4) électronique,
la carte imprimée (4) électronique comprenant une pluralité d'évidements de contact (12),
les éléments de contact (5) comprenant une première extrémité (8) du côté extérieur du boîtier (13) et une deuxième extrémité (9) du côté intérieur du boîtier (13), chacun des éléments de contact (5) comprenant, à l'endroit de sa deuxième extrémité (9), au moins une extension flexible (10) étant capable d'être positionnée dans une première position de repos et une deuxième position de contact, la carte imprimée (4) électronique pouvant être électriquement contactée par l'intermédiaire de, d'une part, la pluralité d'évidements de contact (12) et, d'autre part, les extensions flexibles (10) de la deuxième extrémité (9) des éléments de contact (5), les extensions flexibles (10) étant positionnés dans leur deuxième position et au moins partiellement fléchies dans leur deuxième position,
**caractérisé en ce que**
les deux extensions flexibles (10) sont prévues en forme d'ailes.

4. Boîtier (13) selon la revendication 3 , **caractérisé en ce que** les extensions flexibles (10) sont, dans leur deuxième position, fléchies de manière élastique.

5. Boîtier (13) selon l'une quelconque des revendications 3 ou 4, **caractérisé en ce que** le boîtier (13) comprend un élément de fiche (11) disposé du côté extérieur du le boîtier (13).

## Patentansprüche

1. Verfahren zur Platzierung einer elektronischen Leiterplatte (4) in Kontakt mit mehreren Kontaktelementen (5) in einem Gehäuse (13) zur Aufnahme oder Umschließung der elektronischen Leiterplatte (4),
wobei die elektronische Leiterplatte (4) im Gehäuse (13) aufgenommen wird,
wobei die elektronische Leiterplatte (4) mehrere Kontaktausnehmungen (12) umfasst,
wobei die Kontaktelemente (5) ein erstes Ende (8) an der Außenseite des Gehäuses (13) und ein zweites Ende (9) an der Innenseite des Gehäuses (13) umfassen, wobei jedes der Kontaktelemente (5), am Ort seines zweiten Endes (9), zwei flexible Erweiterungen (10) in der Form von Flügeln umfasst, die in eine erste Ruheposition und eine zweite Kontaktposition positioniert werden können,
wobei das Verfahren umfasst:
- einen ersten Schritt, in dem die elektronische Leiterplatte (4) relativ zum Gehäuse (13) derart platziert wird, dass die zweiten Enden (9) der Kontaktelemente (5) gegenüber den Kontaktausnehmungen (12) angeordnet werden, wobei die flexiblen Erweiterungen (10) in ihre erste Position positioniert werden, und
- einen zweiten Schritt, in dem die elektronische Leiterplatte (4) elektrisch einerseits durch die mehreren Kontaktausnehmungen (12) und andererseits durch die flexiblen Erweiterungen (10) des zweiten Endes (9) der Kontaktelemente (5) in Kontakt platziert wird, wobei die flexiblen Erweiterungen (10) in ihre zweite Position positioniert und mindestens teilweise in ihrer zweiten Position angewinkelt werden.

2. Verfahren nach Anspruch 1,
**dadurch gekennzeichnet, dass** die flexiblen Erweiterungen (10), in ihrer zweiten Position, elastisch angewinkelt werden.

3. Gehäuse (13) mit Kontaktelementen (5) zur Platzierung einer elektronischen Leiterplatte (4) in Kontakt, wobei das Gehäuse (13) eine elektronische Leiterplatte (4) aufnehmen oder umschließen kann,
wobei die elektronische Leiterplatte (4) mehrere Kontaktausnehmungen (12) umfasst,
wobei die Kontaktelemente (5) ein erstes Ende (8) an der Außenseite des Gehäuses (13) und ein zweites Ende (9) an der Innenseite des Gehäuses (13) umfassen,
wobei jedes der Kontaktelemente (5), am Ort seines zweiten Endes (9), mindestens eine flexible Erweiterung (10) umfasst, die in eine erste Ruheposition und eine zweite Kontaktposition positioniert werden kann, wobei die elektronische Leiterplatte (4) elektrisch einerseits durch die mehreren Kontaktausnehmungen (12) und andererseits durch die flexiblen Erweiterungen (10) des zweiten Endes (9) der Kontaktelemente (5) in Kontakt platziert werden kann, wobei die flexiblen Erweiterungen (10) in ihre zweite Position positioniert und mindestens teilweise in ihrer zweiten Position angewinkelt werden,
**dadurch gekennzeichnet, dass** die beiden flexiblen Erweiterungen (10) in der Form von Flügeln bereitgestellt werden.

4. Gehäuse (13) nach Anspruch 3,
**dadurch gekennzeichnet, dass** die flexiblen Erweiterungen (10), in ihrer zweiten Position, elastisch angewinkelt werden.

5. Gehäuse (13) nach einem der Ansprüche 3 oder 4,
**dadurch gekennzeichnet, dass** das Gehäuse (13) ein Steckerelement (11) umfasst, das an der Außenseite des Gehäuses (13) angeordnet ist.

## Claims

1. Method for placing an electronic circuit board (4) in contact with a plurality of contact elements (5) in a housing (13) receiving or surrounding the electronic circuit board (4),
the electronic circuit board (4) being received in the housing (13),
the electronic circuit board (4) comprising a plurality of contact recesses (12),
the contact elements (5) comprising a first end (8) on the outer side of the housing (13) and a second end (9) on the inner side of the housing (13),
each of the contact elements (5) comprising, at the location of its second end (9), two flexible wing-shaped extensions (10) capable of being positioned in a first rest position and a second contact position,
the method comprising:
-- a first step, during which the electronic circuit board (4) is positioned relative to the housing (13) in such a way that the second ends (9) of the contact elements (5) are located facing the contact recesses (12), the flexible extensions (10) being positioned in their first position, and
-- a second step, during which the electronic circuit board (4) is electrically contacted by means of, on the one hand, the plurality of contact recesses (12) and, on the other hand, the flexible extensions (10) of the second end (9) of the contact elements (5), the flexible extensions (10) being positioned in their second position and at least partly bent in their second position.

2. Method according to Claim 1, **characterized in that** the flexible extensions (10) are, in their second position, bent resiliently.

3. Housing (13) with contact elements (5) for contacting an electronic circuit board (4), the housing (13) being able to receive or surround an electronic circuit board (4),
the electronic circuit board (4) comprising a plurality of contact recesses (12),
the contact elements (5) comprising a first end (8) on the outer side of the housing (13) and a second end (9) on the inner side of the housing (13),
each of the contact elements (5) comprising, at the location of its second end (9), at least one flexible extension (10) capable of being positioned in a first rest position and a second contact position, the electronic circuit board (4) being able to be electrically contacted by means of, on the one hand, the plurality of contact recesses (12) and, on the other hand, the flexible extensions (10) of the second end (9) of the contact elements (5), the flexible extensions (10) being positioned in their second position and at least partly bent in their second position, **characterized in that** the two flexible extensions (10) are provided in the form of wings.

4. Housing (13) according to Claim 3, **characterized in that** the flexible extensions (10) are, in their second position, bent resiliently.

5. Housing (13) according to either one of Claim 3 and 4, **characterized in that** the housing (13) comprises a plug element (11) arranged on the outer side of the housing (13).
